# EUROPEAN PATENT APPLICATION

(11) **EP 4 485 072 A1**
(43) Date of publication of application: **01.01.2025**
(21) Application number: 23182592.8
(22) Date of filing: 30.06.2023
(51) Int. Cl.: G03F 7/00

(54) **PATTERN GENERATOR AND METHOD FOR DRIVING PATTERN GENERATOR**

(71) Applicant: MYCRONIC AB, 183 03 Täby (SE)
(72) Inventor: Glimtoft, Martin, 125 58 Älvsjö (SE); Karawajczyk, Andrezej, 117 36 STOCKHOLM (SE); Walther, Jonas, 169 37 Solna (SE)
(74) Representative: AWA Sweden AB

(57) **Abstract**

A pattern generator (1) comprises a pulsed laser light source, a spatial light modulator, a control module, an optical end system (50) and a stage positioning device. The optical end system is arranged for positioning a laser illumination pattern (13) from the spatial light modulator on a writing plane (43). The optical end system further comprises a strip switch (70), configured to optically move a position of the laser illumination pattern on the writing plane in a sweep direction (61), perpendicular to a scan direction (62) of the stage positioning device. The control module is further arranged for generating laser illumination patterns at at least two predetermined positions in the sweep direction. A distance between the positions in the sweep direction is less or equal to a width in the sweep direction of the laser illumination pattern on the writing plane.

## Description

### TECHNICAL FIELD

The present technology refers in general to pattern generators and in particular to pulsed pattern generators and methods for driving pulsed pattern generators.

### BACKGROUND

Pattern generators are today used for many types of purposes. Pattern generators used in lithography systems or photomask lithography systems are required to present very accurate printing properties. One approach to obtain high-quality pattern printing is to use Spatial Light Modulators (SLM), e.g. Digital Micromirror Devices (DMD), Liquid Crystal Displays (LCD), Grating Light Valves (GLV), Planar Light Valves (PLV), Micro Shutter Arrays (MSA), Analogue Spatial Light Modulators (ASLM) and/or Liquid Crystal on Silicon (LCS). The SLM has an array of individually controllable elements arranged for generating an array of imaged elements within an image area on a target surface. The illumination of each individual imaged element is controlled by a respective such element and can be changed between each light pulse of a pulsed laser.

In particular for Direct Writing machines, write speed, both in terms of mm²/min and throughput is one important parameter. A very high pixel rate from the write engine is thereby needed. For application having low resolution requirements, in relation to what may be required in this technical field, the combination between a high pixel rate a large pixel size may lead to very high translation velocities of moving parts of the writing machines. In many types of prior art XY-writers, the stage or wagon velocity and/or acceleration in the X direction quickly becomes unpractically high.

Roughly, the translation velocity for a writing stage in the X direction is given by the modulator pixel rate times the pixel size divided by the number of pixels in the Y direction. As an example, a 2D SLM with 2048 * 4096 micromirrors (X/Y) and 1000 Hz refresh rate for a 1200 nm pixel size would require an X-velocity of ~2.4 m/s. A larger SLM, that is wider in the Y-direction, can be used to reduce this required X velocity. However such larger SLM might be more difficult or expensive to produce. It will also require larger dimensioned illumination optics as well as some parts of the projection optics, which also increase cost and complexity.

There is thus a need for improvements for high write speed applications.

### SUMMARY

A general object of the present technology is to allow for high write speed while keeping physical translation speed on a manageable level.

The above object is achieved by methods and devices according to the independent claims. Preferred embodiments are defined in dependent claims.

In general words, in a first aspect, a pattern generator comprises a pulsed laser light source, a spatial light modulator (SLM), a control module, an optical end system and a stage positioning device. The SLM is optically connected to the pulsed laser light source and is arranged for generating a laser illumination pattern. The control module is arranged for controlling the SLM to generate laser illumination patterns according to print data. The target stage is arranged to enabling holding of a target having a light-sensitive target surface. The optical end system is optically connected to the SLM, and is arranged for positioning the laser illumination pattern on a writing plane intended to coincide with the light-sensitive target surface. The stage positioning device is configured for mechanically changing a relative position between the SLM and the writing plane in a scan direction, parallel to the writing plane. The optical end system further comprises a strip switch. The strip switch is configured to optically move a position of the laser illumination pattern on the writing plane in a sweep direction, parallel to the writing plane but perpendicular to the scan direction. The control module is further arranged for controlling the SLM and the pulsed laser light source in dependence of the position caused by the strip switch to generate individual specimens of the laser illumination patterns at at least two predetermined positions in the sweep direction. A distance between the at least two predetermined positions in the sweep direction relative to a closest other predetermined position is less or equal to a width in the sweep direction of the laser illumination pattern on the writing plane.

In a second aspect, a method for operating a pattern generator comprises providing of print data representing a pattern to be generated. Pulsed laser light is supplied to a SLM. The spatial light module is controlled to generate laser illumination patterns according to the print data. A relative position between the SLM and the writing plane is mechanically changed in a scan direction, parallel to a writing plane. An optical end system is arranged for positioning the laser illumination pattern on the writing plane. A strip switch of the optical end system is controlled to optically move a position of the laser illumination pattern on the writing plane in a sweep direction. The sweep direction is parallel to the writing plane but perpendicular to the scan direction. The controlling of the spatial light module and the supplying of pulsed laser light is further performed in dependence of the controlling of the strip switch for controlling the SLM to generate individual specimens of the laser illumination patterns at at least two predetermined positions in the sweep direction, with a distance in the sweep direction relative to a closest other predetermined position being less or equal to a width in the sweep direction of the laser illumination pattern on the writing plane.

One advantage with the proposed technology is that the full pixel-rate from high speed SLMs is possible to utilize in more writer designs. These solutions contribute to lower velocities in the X direction of the writing stage, less reaction forces and shorter acceleration distances, which in turn leads to a decrease in produced motor heat. The accuracy of the motion of the stage can also be improved. The solution is also scalable to cope with even higher pixel-rates from SLM equipment.

### BRIEF DESCRIPTION OF THE DRAWINGS

The invention, together with further objects and advantages thereof, may best be understood by making reference to the following description taken together with the accompanying drawings, in which:
FIG. 1 is a schematic illustration of a pattern generator; and
FIG. 2 is a schematic cross-sectional side view of a pattern generator;
FIG. 3 is a schematic illustration of a prior art writing process;
FIG. 4 is a schematic illustration of an embodiment of a writing process writing more than one strip simultaneously;
FIG. 5 is a schematic illustration of an embodiment of a writing process with two simultaneous strips using a quasi-static MEMS mirror;
FIG. 6 is a schematic illustration of an embodiment of a writing process with three simultaneous strips using a quasi-static MEMS mirror;
FIG. 7 is a schematic illustration of an embodiment of a writing process with two simultaneous strips using a resonant MEMS mirror;
FIG. 8 is a schematic illustration of an embodiment of a writing process with three simultaneous strips using a resonant MEMS mirror;
FIG. 9 is a schematic illustration of an embodiment of a writing process with four simultaneous strips using a resonant MEMS mirror; and
FIG. 10 is a flow diagram of steps of an embodiment of a method for operating a pattern generator.

### DETAILED DESCRIPTION

Throughout the drawings, the same reference numbers are used for similar or corresponding elements.

For a better understanding of the proposed technology, it may be useful to begin with a brief overview of a pattern generator.

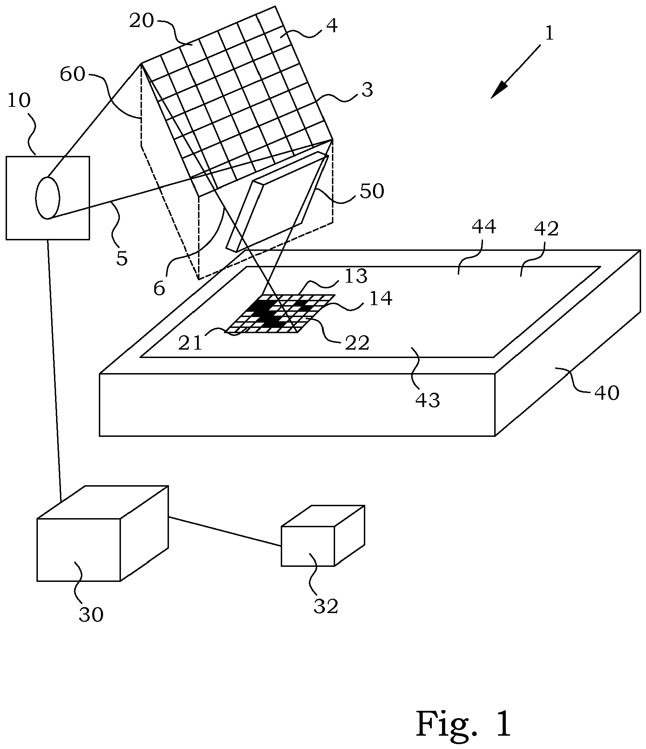

Figure 1 illustrates schematically a pattern generator 1 based on an SLM 20. Note that the figure only depicts the principles of the operation of the pattern generator 1 and the cooperation between its different parts, which means that details of the geometric positions and designs of the figure are not of importance. The SLM 20 is here illustrated as an array 3 of individually controllable elements 4, in this embodiment radiation reflecting elements. A pulsed laser light source 10 produces pulsed light 5 that impinges on the array 3 and will be reflected into a set of exposure beams 6 towards a target surface 44 of a target 42. The target surface 44 is typically supported by a target support 40. The SLM 20 and the pulsed laser light source 10 are controlled by a control module 30, synchronizing the light pulses with the settings of the SLM 20. The individual elements 4 of SLM 20 are thereby controllable to admit reflection or to suppress reflection separately for each light pulse. The control of the SLM 20 is based on print data that is stored on a memory 32 connected to the control module 30.

The light leaving the active part of the SLM 20 is directed to the target surface 44 via an optical end system 50. On the target surface 44, the light forms an array 21 of imaged elements 22. Together, the imaged elements 22 forms a laser illumination pattern 13 on an imaged area 14. The illumination of each individual imaged element 22 is thereby controlled by a respective element 4 of the SLM 20. Typically, there is a nominal optical scaling of the imaged area 14 in relation to the SLM array 20. This nominal scaling is a uniform scaling determined by different design parameters, such as different distances, and by ordinary optics. The arrangements for achieving such a nominal scaling are well-known by any person skilled in the art and are not further discussed.

The SLM 20 can be configured in many different ways. The details of the operation of the SLM 20 are not of crucial importance for the present ideas, as long as the individual control of the elements 4 is provided and the SLM 20 gives rise to the array 21 of imaged elements 22 in the imaged area 14 on the target surface 44.

After an exposure of the imaged area 14 according to the individual settings of the elements 4 of the SLM 20, the imaged area 14 can be moved. This may typically be performed by mechanically moving the SLM 20 relative the target support 40, by moving the target support 40, the SLM 20 or both. The movement is performed using a stage positioning device 60.

In other words, in one embodiment, a pattern generator 1 comprises a pulsed laser light source 10 and a SLM 20, optically connected to the pulsed laser light source 10. The SLM 20 is arranged for generating a laser illumination pattern 13. A control module 30 is arranged for controlling the SLM 20 to generate the laser illumination patterns 13 according to print data. A target stage 40 is arranged to enabling holding of a target 42 having a light-sensitive target surface 44. An optical end system 50 is optically connected to the SLM 20 and is arranged for positioning the laser illumination pattern 13 on a writing plane 43 intended to coincide with the light-sensitive target surface 44.

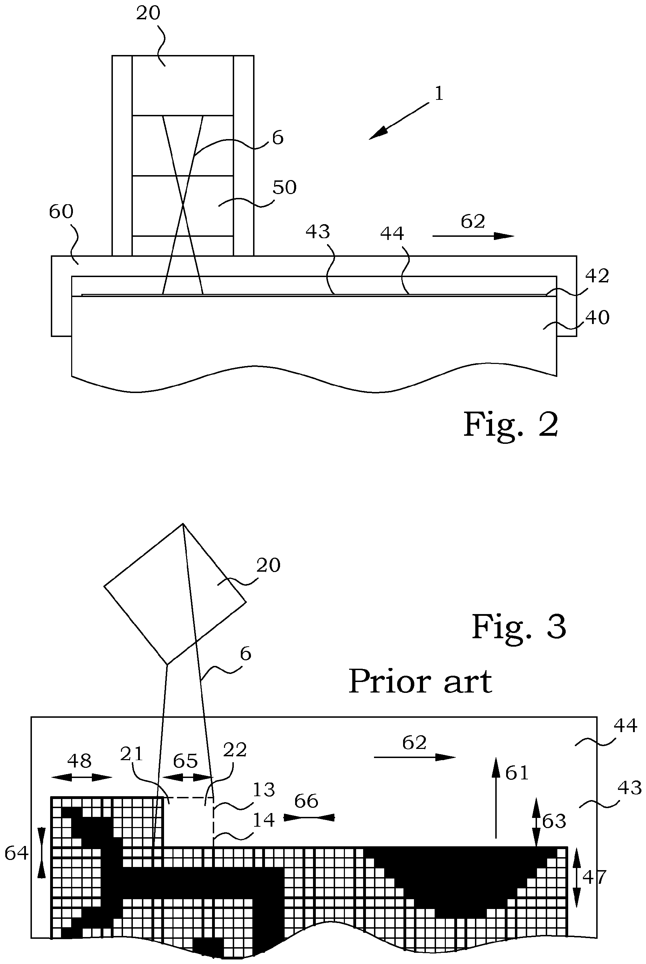

Figure 2 is a schematic cross-section of the pattern generator 1. With reference to Figure 2, a stage positioning device 60 is configured for mechanically changing a relative position between the SLM 20 and the writing plane 43 in a scan direction 62, parallel to the writing plane 43.

Figure 3 schematically illustrates the operation of a prior-art pattern generator 1. The SLM 20 directs a set of exposure beams 6 towards the target surface 44 at the writing plane 43, forming a laser illumination pattern 13 in an imaged area 14 by the array 21 of imaged elements 22. The SLM 22 can be translated in relation to the target surface 44 is scan direction 62, also referred to as the X direction. The imaged area 14 has a width 48 in the scan direction 62. Between each laser pulse, the SLM 22 is moved in relation to the target surface 44 an X pulse distance 65. In some applications, this X pulse distance 65 may be equal to the width 48 of the imaged area 14, which means that a new laser illumination pattern 13 will be created side-by-side of the previous one. In other applications, an overlap 66, may be used, e.g. for mitigating edge effects. This overlap 66 is equal to the difference between the width 48 of the imaged area 14 and the X pulse distance 65.

When the full intended width, in the scan direction 62, has been illuminated, the SLM 22 returns to the start of the scan again, and a translation 63 of the target surface 44 relative to the SLM 20 is performed in a sweep direction 61, perpendicular to the scan direction 62. The sweep direction 61 is also referred to as the Y direction. A new scan can then begin. A height 47 of the imaged area 14 in the sweep direction may be equal to the translation 63, resulting in scans being positioned side-by-side. However, in analogy with the X pulse distance 65, the translation 63 may be smaller than the height 47 of the imaged area 14, resulting in an overlap 64 of the scans.

As briefly discussed in the background, if the speed of the retrieving of print data, and the rate with which the SLM 20 can be switched, are high, the required velocity for causing the appropriate relative movement between the SLM 20 and the target surface 44 may be awkwardly high.

According to ideas of the present technology, by distributing the pixel rate into several strips written in parallel in Y direction, the velocity in the X-direction can be reduced. To achieve such a parallel writing in with a 2D SLM, the imaged area resulting from the SLM needs to be shifted in the Y-direction in a time frame equal to the refresh rate of the SLM. As will be discussed further below, the Y-shift can be achieved in several ways.

To this end, in one embodiment, the optical end system further comprises a strip switch. The strip switch is configured to optically move a position of the laser illumination pattern on the writing plane in a sweep direction, parallel to the writing plane but perpendicular to the scan direction. The control module is furthermore arranged for controlling the SLM and the pulsed laser light source in dependence of the position caused by the strip switch. This control is made to generate individual specimens of the laser illumination patterns at at least two predetermined positions in the sweep direction. A distance in the sweep direction relative to a closest other predetermined position is less or equal to a width, in the sweep direction, of the laser illumination pattern on the writing plane.

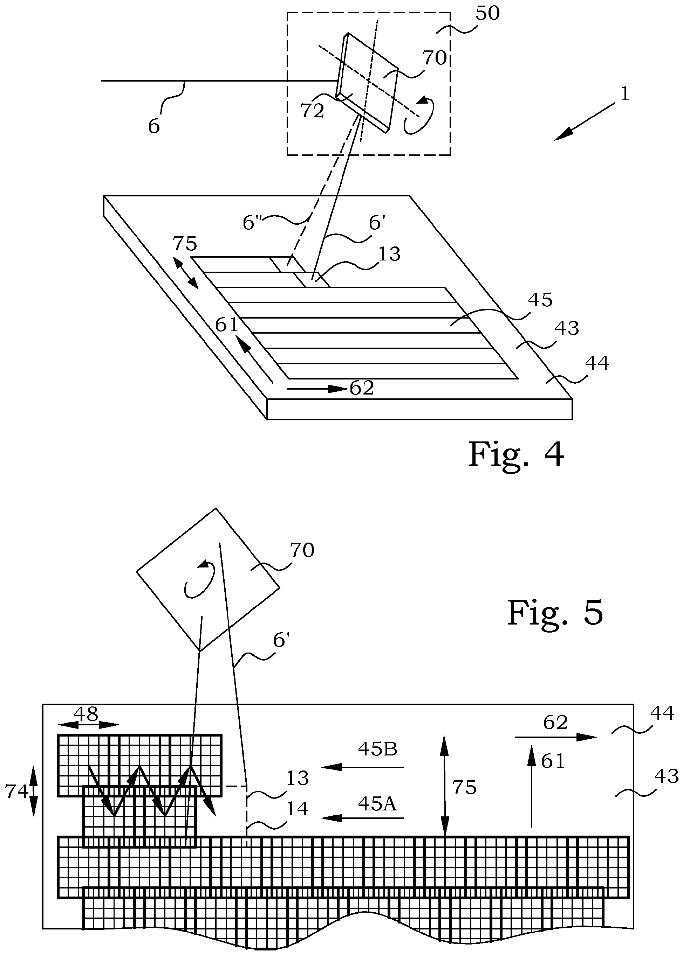

One embodiment of this is schematically illustrated by Figure 4. A set of exposure beams 6 is provided to the optical end system 50. A strip switch 70, in this particular embodiment a microelectromechanical-system (MEMS) mirror 72, is arranged for switching the direction of the set of exposure beams 6 towards the target surface 44. The strip switch 70 is thus configured to optically move a position of the laser illumination pattern 13 on the writing plane 43 in a sweep direction 61, parallel to the writing plane 43 but perpendicular to the scan direction 62. In this way, a set of switched exposure beams 6' can be directed to either of two different strips 45 in the scan direction 62. (The dotted line 6" indicates a previous direction of the switched exposure beams, directed to the other strip 45 presently being printed.) As will be discussed further below, the basic idea is not limited to two strips 45, but can be applied also to more than two strips 45. The two strips 45 are displaced relative each other in the sweep direction 61, as will be discussed more in detail here below.

As mentioned above, the control module is furthermore arranged for controlling the SLM and the pulsed laser light source in dependence of the position caused by the strip switch 70 to generate individual specimens of the laser illumination patterns 13 at at least two predetermined positions in the sweep direction 61.

Since two strips 45 are written in parallel, the need for moving the relative position between the SLM and the writing plane in a scan direction 62, with an unchanged rate of provided print data, is reduced by approximately a factor of 2. In other words, the optical switching between strips 45 in the sweep direction 61 allows for a reduction in the physical motion speed of the SLM relative the writing plane in the scan direction 62.

A distance 74 in the sweep direction 61 relative to a closest other predetermined position is less or equal to a width, in the sweep direction 61, of the laser illumination pattern 13 on the writing plane 43. This ensures that the complete intended area to be written at the target surface 44 in the sweep direction 61 is illuminated at least once.

If more than two strips, written in parallel, are used, the possible reduction in relative physical speed becomes even higher.

Figure 5 illustrates schematically an embodiment of a printing process. The strip switch moves the position of the laser illumination pattern 13 on the writing plane in a cyclic motion pattern. A complete cycle of the cyclic motion pattern is performed within a certain period. This period is less or equal to a quotient of a width 48 in the scan direction 62 of the laser illumination pattern 13 on the writing plane divided with a constant scan velocity of the relative position between the SLM and the writing plane. This ensures that the complete intended area to be written at the target surface in the scan direction 62 is illuminated at least once. The SLM and the pulsed laser light are controlled, synchronized with the cyclic motion pattern, to generate the individual specimens of the laser illumination patterns 13 at the at least two predetermined positions in the sweep direction 61.

Described differently, a laser illumination pattern 13 is written in a first strip 45A but letting the pulsed laser light of the set of switched exposure beams reach the target surface. In most applications, the laser pule is short enough to allow the relative position change between the SLM and the writing plane to continue also during the exposure. When this exposure is over, the relative position change continues to move the position of the exposed area in the scan direction 62. At the same time, the strip switch changes the position of the exposure in the sweep direction 61, to a second strip 45B. A next laser pulse is admitted and a laser illumination pattern 13 is written in the second strip 45B. The strip switch then returns the exposure beams to the first strip 45A and the cyclic motion pattern can start allover again.

After completing the writing of the strips, two or more, the relative position between the SLM and the writing plane is returned to the starting point in the scan direction. At the same time the relative position between the SLM and the writing plane in the sweep direction is also changed to prepare for the writing of new strips. The stage positioning device is in other words preferably further configured for mechanically changing a relative position between the SLM and the writing plane in steps 75 in the sweep direction 61. In order to reach all intended exposure positions, an amplitude 74 of the cyclic motion pattern in the sweep direction 61 is in a general case equal or larger than the steps 75 in the sweep direction times (m-1)/m, where m is the number of predetermined positions in said sweep direction 61. In the present embodiment with two stripes, an amplitude 74 of the cyclic motion pattern in the sweep direction 61 is at least half the step 75 in the sweep direction 61.

In Figure 5, as compared with Figure 3, the actual pattern that is written has been omitted for increasing the readability of the figure.

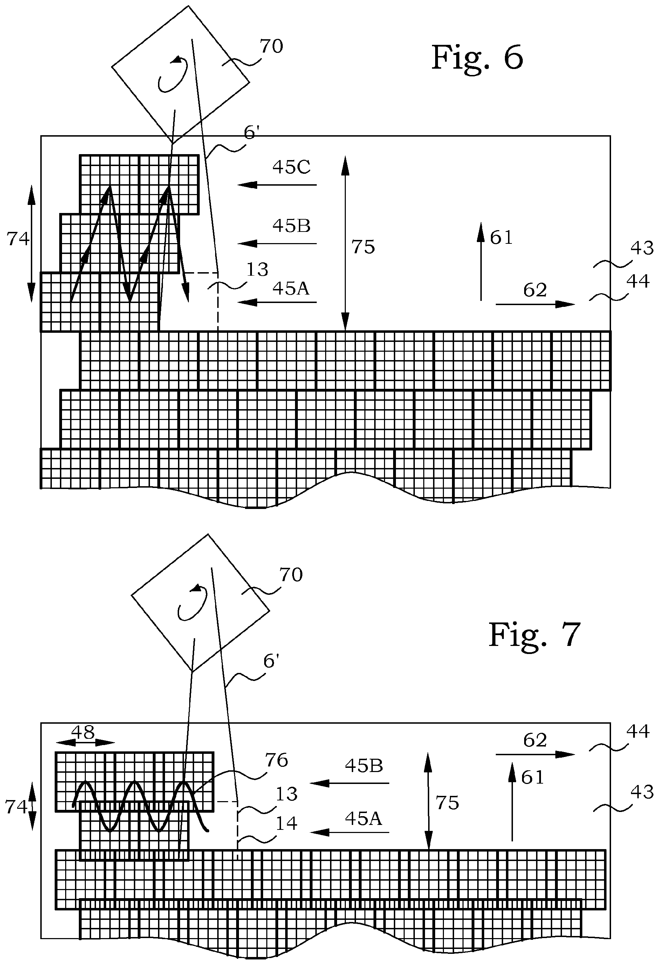

In Figure 6, a writing process involving more than two simultaneous strips 45A-C is schematically illustrated. The control module is thereby arranged for controlling the SLM to generate laser illumination patterns at more than two predetermined positions in the sweep direction, wherein the more than two predetermined positions are equidistant in the sweep direction. In this particular embodiment, there are three equidistant strips 45A-C. The relative speed between the SLM and the writing plane here becomes about one third comparing to a situation where the strips are written consecutively. The necessary amplitude 74 of the switch in the sweep direction is at least 2/3 compared to the step 75 between consecutive scans.

In this particular embodiment, the distance in the scan direction between the individual laser illumination pattern 13 of the respective strips 45A-C is also equidistant. In other words, the laser illumination pattern 13 of strip 45B is displaced in the scan direction relative the laser illumination pattern 13 of strip 45A by the same amount that the laser illumination pattern 13 of strip 45C is displaced in the scan direction relative the laser illumination pattern 13 of strip 54B. However, as will be discussed further below, this is not absolutely necessary and depends on the operation possibilities of the strip switch. In the present embodiment, the change rate of the strip switch is twice between strip 45C and 45A compared to the rate between strip 45A and 45B.

One possibility to implement the strip switch is to use a microelectromechanical-system (MEMS) mirror. MEMS mirrors are provided in different versions. In different embodiment, a quasi-static MEMS mirror or a resonant MEMS mirror can be used.

The Figures 5 and 6 may illustrate an implementation using a quasi-static MEMS mirror. Here the position in the sweep direction 61 can be halted in well-determined positions. This allows for selection of the equidistant strips at selected points in time. In these figures, the points in time are selected to be regular, which may be an advantage when controlling the laser pulse timing. However, in other embodiments, the selected points in time may also be different for the different strip changes.

A quasi-static MEMS mirror will in other words shift the 2D-SLM image - the laser illumination pattern 13 -to discrete positions in the sweep direction 61. The velocity in the scan direction 62 is then reduced by a factor equal to the number of different positions in the sweep direction 61. A mirror cycle thereby consists of a few, typically 2-5, small movements in the sweep direction followed by a large return movement in the negative sweep direction.

Another choice of MEMS mirrors is a resonant MEMS mirror. Such a mirror oscillates continuously between different states, in accordance with a resonance frequency of the system. This opens up for relatively cost-efficient and simple arrangements, but has the drawback that the point in time when different positions are reached is not independently controllable. In other words, the strip switch moves the position of the laser illumination pattern on the writing plane in a cyclic motion pattern with a frequency equal to a resonance frequency of the MEMS mirror.

Figure 7 illustrates schematically an embodiment of a dual-strip writing that could be achieved using a resonant MEMS mirror. The curve 76 indicates the motion of the position for the center of the laser illumination pattern 13 if a laser would be constantly turned on. This curve 76 is composed by a constant velocity in the scan direction 62 of the mechanical movement caused by the stage positioning device and an oscillating motion in the sweep direction 61 caused by the resonating MEMS mirror. In this embodiment, at each end point in the oscillation, a laser pule is turn on and laser illumination pattern 13 is written on the target surface 44.

A resonant MEMS mirror would move the 2D-SLM image - the laser illumination pattern 13 - to different possible positions in the sweep direction 61. The velocity in scan direction 62 is reduced by number of used positions in the sweep direction 61. The mirror moves image in the sweep direction 61 with an oscillation frequency corresponding to a fraction, typically 2-4, of the SLM update frequency. The positions in the sweep direction are the outcome of the combination of exposure light pulse rate, mirror deflection amplitude and frequency, and laser synchronization in relation to resonant phase. For 2-4 positions in the sweep direction, the strips can be placed exactly equidistant.

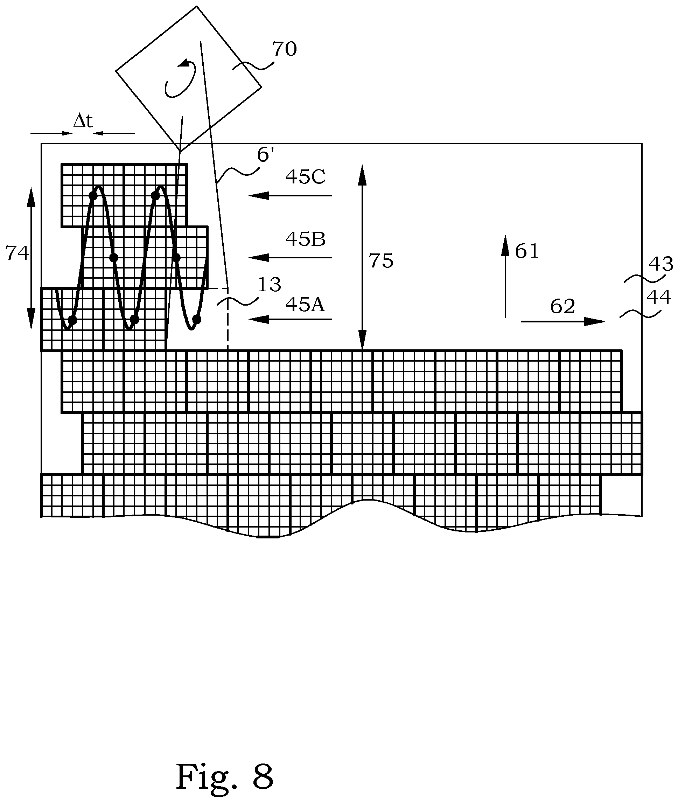

Figure 8 illustrates schematically another embodiment of a three-strip writing that could be achieved using a resonant MEMS mirror. Here, three equidistant positions in the sweep direction 61 are selected. When the resonant mirror motion passes these positions, a laser pulse is emitted and a laser illumination pattern 13 is written on the target surface 44. In order to place the laser illumination patterns 13 equidistant in the sweep direction, and at the same time have a same time difference Δt between the exposures, the amplitude 74 of the resonant mirror movement has to be larger than for the quasi-static MEMS mirror case, and may even be larger than the step 75 in the sweep direction 61.

Alternatively, if two of the exposure instances occur at the turning point of the MEMS mirror, the laser pulse has to be controlled to occur with different time separations.

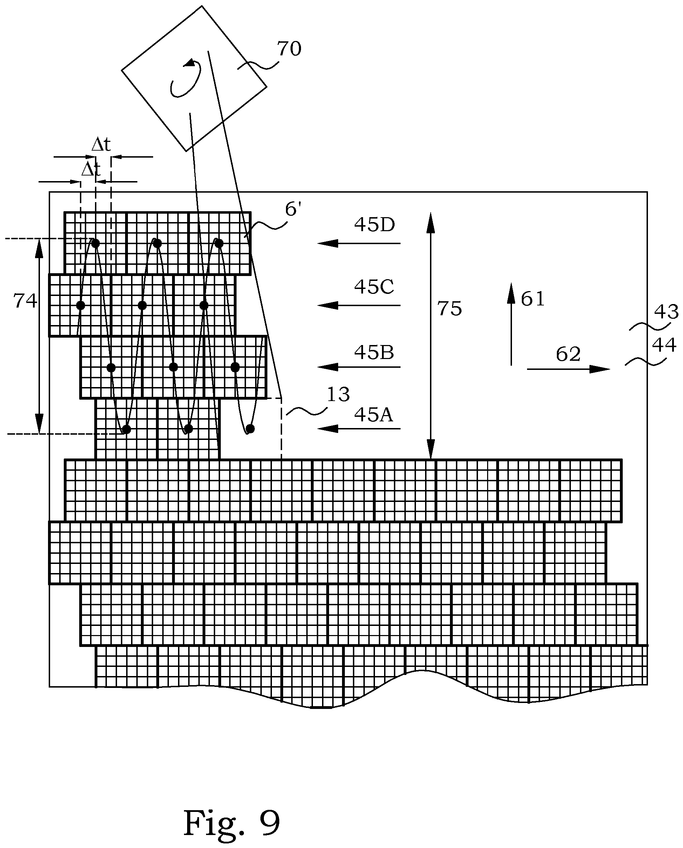

Figure 9 illustrates schematically another embodiment of a four-strip writing that could be achieved using a resonant MEMS mirror. In this embodiment, the amplitude 74 of the resonant mirror movement is almost as large as the step 75 in the sweep direction 61. Four equidistant strips 45A-D are possible to achieve in parallel writing. The necessary mechanical speed in the scan direction can thereby be reduced to ¼. Also in this embodiment, one may notice that the time difference Δt between the writing occasions for the different strips is the same, i.e. the shift between the different strips is equidistant also in the scan direction 62. This is possible to achieve together with the positioning of the four strips equidistant in the sweep direction 61. The laser pulses thus have to be controlled to occur at these regular time instances, with a certain phase shift between the resonant motion and the occasions for the laser pulses. Since the SLM typically is moved constantly relative the target surface, the exposure occasions, equidistant in time, also results in equidistant spatial offsets of the laser illumination patterns 13, as mentioned above.

The present technical solution is particularly well suited if the pattern generator is a direct writer. The speed of writing is then of most significant importance.

However, the technical solution may also be applicable to e.g. mask writers, even if the velocity in scan direction currently typically is not critically high for such write engine. Such writers are typically based on an Acousto-Optic Modulator (AOM) and/or Acousto-Optic Deflector (AOD) writer operation. However, the present alternation between strips may be used for alternating the sweeps between several strips to reduce the required X-velocity or number of strokes for multipass writing. It is however presently concluded that such an implementation may require a large redesign to fit the mirror after the deflector.

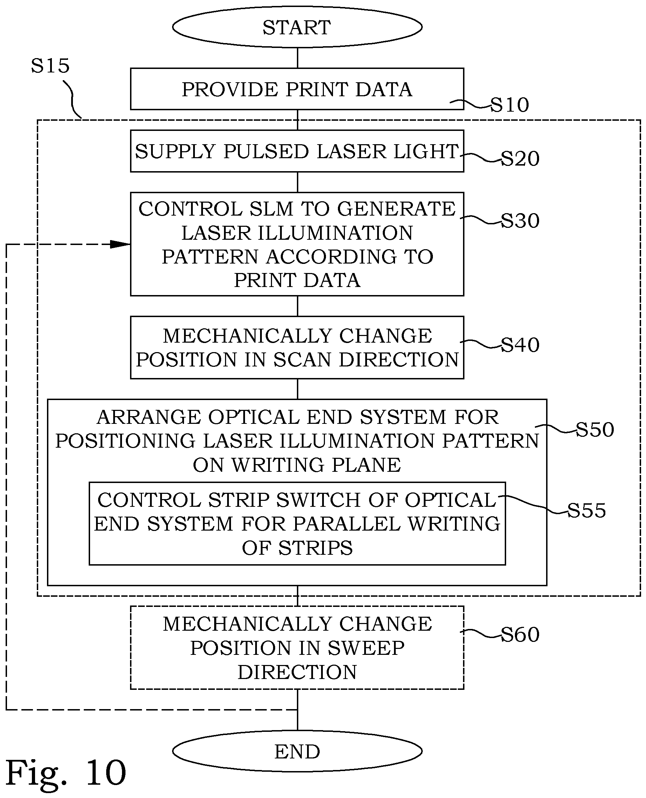

Figure 10 is a flow diagram of steps of an embodiment of a method for operating a pattern generator. In step S10, print data is provided, representing a pattern to be generated. Pulsed laser light is in step S20 supplied to a SLM. The SLM is in step S30 controlled to generate laser illumination patterns according to the print data. In step S40, a relative position between the SLM and the writing plane is mechanically changed in a scan direction, parallel to the writing plane. In step S50, an optical end system is arranged for positioning the laser illumination pattern on a writing plane. In step S55, a strip switch of the optical end system is controlled to optically move a position of the laser illumination pattern on the writing plane in a sweep direction, parallel to the writing plane but perpendicular to the scan direction.

The controlling of the spatial light module and the supplying of pulsed laser light is further performed in dependence of the controlling of the strip switch for controlling the SLM to generate individual specimens of the laser illumination patterns at at least two predetermined positions in the sweep direction, with a distance in the sweep direction relative to a closest other predetermined position being less or equal to a width in the sweep direction of the laser illumination pattern on the writing plane.

The steps are illustrated as consecutive steps in Figure 10. However, in practice, the steps S20-S55, and optionally also step S10, are performed in cooperation with each other and typically at least partially overlapping in time. This is illustrated by the dotted box S15.

In one embodiment, the step S55 of controlling the strip switch moves the position of the laser illumination pattern on the writing plane in a cyclic motion pattern. A complete cycle of the cyclic motion pattern is performed within a period less or equal to a quotient of a width in the scan direction of the laser illumination pattern on the writing plane divided with a constant scan velocity of the relative position between the SLM and the writing plane. The controlling of the spatial light module and the supplying of pulsed laser light are synchronized with the cyclic motion pattern to generate the individual specimens of the laser illumination patterns at the at least two predetermined positions in the sweep direction.

In a preferred embodiment, the method comprises the further step S60, in which a relative position between the SLM and the writing plane is mechanically changed in steps in the sweep direction. An amplitude of the cyclic motion pattern in the sweep direction is equal or larger than the steps in the sweep direction.

In one embodiment, the step S30 of controlling the SLM controls the SLM to generate laser illumination patterns at more than two predetermined positions in the sweep direction. The more than two predetermined positions are equidistant in the sweep direction.

In one embodiment, the step S55 of controlling the strip switch comprises controlling of a microelectromechanical-system mirror.

In a further embodiment, the step S55 of controlling the strip switch comprises controlling of a resonant microelectromechanical-system mirror. The step S55 of controlling the strip switch comprises moving the position of the laser illumination pattern on the writing plane in a cyclic motion pattern with a frequency equal to a resonance frequency of the microelectromechanical-system mirror.

In another further embodiment, the step S55 of controlling the strip switch comprises controlling of a quasi-static microelectromechanical-system mirror.

The embodiments described above are to be understood as a few illustrative examples of the present invention. It will be understood by those skilled in the art that various modifications, combinations and changes may be made to the embodiments without departing from the scope of the present invention. In particular, different part solutions in the different embodiments can be combined in other configurations, where technically possible. The scope of the present invention is, however, defined by the appended claims.

## Claims

1. A pattern generator (1), comprising:
- a pulsed laser light source (10);
- a spatial light modulator (20), optically connected to said pulsed laser light source (10) and arranged for generating a laser illumination pattern (13);
- a control module (30), arranged for controlling said spatial light modulator (20) to generate laser illumination patterns (13) according to print data;
- a target stage (40), arranged to enabling holding of a target (42) having a light-sensitive target surface (44);
- an optical end system (50), optically connected to said spatial light modulator (20), and arranged for positioning said laser illumination pattern (13) on a writing plane (43) intended to coincide with said light-sensitive target surface (44); and
- a stage positioning device (60), configured for mechanically changing a relative position between said spatial light modulator (20) and said writing plane (43) in a scan direction (62), parallel to said writing plane (43);
wherein said optical end system (50) further comprises a strip switch (70), configured to optically move a position of said laser illumination pattern (13) on said writing plane (43) in a sweep direction (61), parallel to said writing plane (43) but perpendicular to said scan direction (62); and
wherein said control module (30) being further arranged for controlling said spatial light modulator (20) and said pulsed laser light source (10) in dependence of said position caused by said strip switch (70) to generate individual specimens of said laser illumination patterns (13) at at least two predetermined positions in said sweep direction (61), with a distance in said sweep direction relative to a closest other predetermined position being less or equal to a width (47) in said sweep direction (61) of said laser illumination pattern (13) on said writing plane (43).

2. The pattern generator according to claim 1, **characterized in that** said strip switch (70) moves said position of said laser illumination pattern (13) on said writing plane (43) in a cyclic motion pattern, a complete cycle of which is performed within a period less or equal to a quotient of a width (48) in said scan direction (62) of said laser illumination pattern (13) on said writing plane (43) divided with a constant scan velocity of said relative position between said spatial light modulator (20) and said writing plane (43), wherein said spatial light modulator (20) and said pulsed laser light source (10) are controlled, synchronized with said cyclic motion pattern, to generate said individual specimens of said laser illumination patterns (13) at said at least two predetermined positions in said sweep direction (61).

3. The pattern generator according to claim 2, **characterized in that** said stage positioning device (60) being further configured for mechanically changing a relative position between said spatial light modulator (20) and said writing plane (43) in steps (75) in said sweep direction (61), whereby an amplitude (74) of said cyclic motion pattern in said sweep direction (61) is equal or larger than said steps (75) in said sweep direction (61) times (m-1)/m, where m is the number of predetermined positions in said sweep direction (61).

4. The pattern generator according to any one of the claims 1 to 3, **characterized in that** said control module (30) being arranged for controlling said spatial light modulator (20) to generate laser illumination patterns (13) at more than two predetermined positions in said sweep direction (61), wherein said more than two predetermined positions are equidistant in said sweep direction (61).

5. The pattern generator according to any one of the claims 1 to 4, **characterized in that** said strip switch (70) comprises a microelectromechanical-system mirror (72).

6. The pattern generator according to claim 5, **characterized in that** said microelectromechanical-system mirror (72) is a resonant microelectromechanical-system mirror, whereby said strip switch (70) moves said position of said laser illumination pattern (13) on said writing plane (43) in a cyclic motion pattern with a frequency equal to a resonance frequency of said microelectromechanical-system mirror.

7. The pattern generator according to claim 5, **characterized in that** said microelectromechanical-system mirror (72) is a quasi-static microelectromechanical-system mirror.

8. The pattern generator according to any one of the claims 1 to 7, **characterized in that** said pattern generator (1) is a direct writer.

9. A method for operating a pattern generator, comprising the steps of:
- providing (S10) print data representing a pattern to be generated;
- supplying (S20) pulsed laser light to a spatial light modulator (20);
- controlling (S30) said spatial light module (20) to generate laser illumination patterns (13) according to said print data;
- mechanically changing (S40) a relative position between said spatial light modulator (20) and a writing plane (43) in a scan direction (62), parallel to said writing plane (43);
- arranging (S50) an optical end system (50) for positioning said laser illumination pattern (13) on said writing plane (43);
- controlling (S55) a strip switch (70) of said optical end system (50) to optically move a position of said laser illumination pattern (13) on said writing plane (43) in a sweep direction (61), parallel to said writing plane (43) but perpendicular to said scan direction (62);
wherein said controlling (S30) of said spatial light module (20) and said supplying (S20) of pulsed laser light is further performed in dependence of said controlling (S55) of said strip switch (70) for controlling said spatial light modulator (20) to generate individual specimens of said laser illumination patterns (13) at at least two predetermined positions in said sweep direction (61), with a distance (63) in said sweep direction (61) relative to a closest other predetermined position being less or equal to a width (47) in said sweep direction (61) of said laser illumination pattern (13) on said writing plane (43).

10. The method according to claim 9, **characterized in that** said step of controlling said strip switch moves said position of said laser illumination pattern on said writing plane in a cyclic motion pattern, a complete cycle of which is performed within a period less or equal to a quotient of a width in said scan direction of said laser illumination pattern on said writing plane divided with a constant scan velocity of said relative position between said spatial light modulator and said writing plane; wherein said controlling of said spatial light module and said supplying of pulsed laser light are synchronized with said cyclic motion pattern to generate said individual specimens of said laser illumination patterns at said at least two predetermined positions in said sweep direction.

11. The method according to claim 10, **characterized by** comprising the further step of:
- mechanically changing (S60) a relative position between said spatial light modulator (20) and said writing plane (43) in steps (75) in said sweep direction (61), whereby an amplitude (74) of said cyclic motion pattern in said sweep direction (61) is equal or larger than said steps (75) in said sweep direction (61).

12. The method according to any one of the claims 9 to 11, **characterized in that** said step of controlling (S30) said spatial light module (20) controls said spatial light modulator (20) to generate laser illumination patterns (13) at more than two predetermined positions in said sweep direction (13), wherein said more than two predetermined positions are equidistant in said sweep direction (61).

13. The method according to any one of the claims 9 to 12, **characterized in that** said step of controlling (S55) said strip switch (70) comprises controlling of a microelectromechanical-system mirror (72).

14. The method according to claim 13, **characterized in that** said step of controlling (S55) said strip switch (70) comprises controlling of a resonant microelectromechanical-system mirror, whereby said step of controlling (S55) said strip switch (20) comprises moving said position of said laser illumination pattern (13) on said writing plane (43) in a cyclic motion pattern with a frequency equal to a resonance frequency of said microelectromechanical-system mirror.

15. The method according to claim 13, **characterized in that** said step of controlling (S55) said strip switch (70) comprises controlling of a quasi-static microelectromechanical-system mirror.
